# EUROPEAN PATENT SPECIFICATION

(11) **EP 2 553 048 B1**
(45) Date of publication and mention of the grant of the patent: **16.08.2017**
(21) Application number: 11721110.2
(22) Date of filing: 24.03.2011
(51) Int. Cl.: C09K 11/08, H01L 33/50, C09K 11/02

(54) **LUMINESCENT CONVERTER**
LEUCHTENDER WANDLER
CONVERTISSEUR LUMINESCENT

(30) Priority: 29.03.2010 EP 10158154
(43) Date of publication of application: 06.02.2013
(73) Proprietor: Koninklijke Philips N.V., 5656 AE Eindhoven (NL); Philips Intellectual Property & Standards GmbH, 20099 Hamburg (DE)
(72) Inventor: KOOLE, Roelof, NL-5656 AE Eindhoven (NL); HOUTEPEN, Arjan Jeroen, NL-5656 AE Eindhoven (NL); RONDA, Cornelis Reinder, NL-5656 AE Eindhoven (NL)
(74) Representative: Rüber, Bernhard Jakob
(86) International application number: PCT/IB2011/051256
(87) International publication number: WO 2011/121503

(56) References cited:
- WO-A1-03/079457
- WO-A1-2009/120688
- WO-A2-2007/067257
- WO-A2-2010/023657
- US-A1- 2009 010 608

## Description

### FIELD OF THE INVENTION

The invention relates to a method of manufacturing a luminescent converter, and to a solar power generator comprising such a luminescent converter.

### BACKGROUND OF THE INVENTION

US 2009/0010608 A1 discloses a luminescent solar concentrator (LSC) that is used to absorb a certain part of the spectrum of sunlight, wherein the absorbed energy is reemitted at a larger wavelength, which matches the absorption characteristics of an associated solar cell. In a particular embodiment, the LSC may comprise quantum dots of PbSe as a luminescent material.

*The* WO 2007/067257 A2 *discloses a frequency converter comprising quantum dots or nanoparticles that are encapsulated in a polymer matrix. Moreover, the document refers to the use of "magic-sized" nanocrystals*.

### SUMMARY OF THE INVENTION

Based on this background, it was the object of the present invention to provide means for converting light energy, particularly of sunlight, with improved characteristics in terms of efficiency and cost.

This object is achieved by a solar power generator according to claim 1. Preferred embodiments are disclosed in the dependent claims.

*The invention relates to a solar power generator comprising a luminescent converter of the kind described below as a luminescent sonar concentrator (LSC) in combination with a solar cell that is arranged to receive light emissions of the LSC. The LSC can be used to collect incident (sun) light in a larger area, convert it to a larger wavelength, and concentrate it onto the solar cell. The comparatively expensive solar cell can hence be limited to small regions.*

A luminescent converter is characterized in that it comprises magic-sized clusters of a luminescent material. A magic-sized cluster, which will be abbreviated "MSC" in the following, is a small crystallite that is thermodynamically stable because it comprises a specific ("magic") number of atoms. The number of atoms of which a MSC is constituted is a discrete value, because at exactly that discrete (magic) number a thermodynamic minimum is achieved, where the activation energy for increasing or decreasing the number of atoms is significantly larger than kT. Therefore, there is only a limited number of discrete sizes of MSCs that are stable. This is different from the case of larger nanocrystals (e.g. quantum dots), where the activation energy to add or remove atoms is close to or smaller than kT, with the result that the number of atoms is not restricted to certain discrete values. The transition from discrete-sized MSCs to a continuum of QD-sizes is in the range of 2-3 nm. More information about MSCs and procedures to produce them may be found in literature (e.g. WO 2009/120688 A1; Evans et al.: "Ultrabright PbSe Magic-sized Clusters", Nano Letters 2008, 8(9), 2896-2899; these documents are incorporated into the present application by reference).

The use of MSCs as a luminescent material turns out to be favorable for various reasons. The absorption and reemission spectra of the MSCs can for instance be chosen such that a large part of the solar spectrum is absorbed, and that it is reemitted at a wavelength that matches very well the characteristics of solar cells, making the luminescent converter suited for a use in a luminescent solar concentrator (LSC). Moreover, the overlap between absorption and emission spectra can be made small, minimizing losses due to reabsorption of photons. Furthermore, MSCs often have a high quantum efficiency, which improves the performance of the luminescent converter.

The MSCs of the luminescent converter are preferably crystallites with a diameter of not more than 3 nm.

Moreover, the MSCs are preferably symmetric crystallites. In this way the number of surface atoms is minimized, yielding a thermodynamically stable composition and with a very low concentration of lattice defects that might quench the luminescence.

As to their chemical composition, the MSCs preferably comprise a semiconductor, most preferably a compound of two elements taken from groups IV and VI of the periodic table of elements, respectively. Other possible materials comprise compounds of two elements taken from groups II and VI or III and V of the periodic table of elements. MSCs of single elements from the IV group are also included. Particularly preferred examples of such compounds comprise lead salts, for example PbSe, PbTe or PbS. Other applicable compounds are for example CdSe, InP, GaAs, and Si.

The MSCs may be composed of a single homogeneous material. In a preferred embodiment, the MSCs are covered with a coating. In this way the favorable characteristics of the MSCs can be supplemented with additional positive features depending on the type of coating used. The coating may for example comprise an organic material and/or an inorganic semiconductor like PbS. The coating may for instance passivate the surface of an MSC, thus protecting it and increasing the lifetime of the luminescent converter.

The MSCs or the coating of the MSCs (if present) may optionally comprise a line-emitting dopant that helps to concentrate the emissions of the MSCs to a small range of wavelengths. The line-emitting dopant may particularly be a rare-earth element (ion) like Nd, Dy, Ho, Er, or Tm.

The MSCs of the luminescent converter may all be of the same size, i.e. comprise exactly the same number of atoms. Alternatively, the MSCs of the luminescent converter may belong to at least two classes of crystallites having different sizes. As the absorption and emission behavior of the MSCs depend on their size, the spectral characteristics of the luminescent converter can be adjusted via the size-distribution of the MSCs. The sizes of MSCs may most preferably be selected in such a way that an energy transfer can take place between the MSCs of different sizes.

In order to reduce losses due to self-absorption, the distribution of MSC sizes in the aforementioned embodiment is preferably chosen in such a way that the concentration of the MSCs is inversely related to their size (i.e. the concentration of big MSCs is smaller than the concentration of small MSCs).

In another preferred embodiment of the invention, the concentration of the MSCs varies spatially within the luminescent converter. In this way the absorption and emission characteristics can optimally be adapted to the geometrical design of the converter. It is preferred in this respect that the concentration of the MSCs has lower values near at least one border of the luminescent converter, particularly a border through which light is emitted.

Besides the MSCs, the luminescent converter may comprise another fluorophore as an additional luminescent material. Said fluorophore may for instance be spread over the same space (matrix) as the MSCs, and/or it may be disposed in a coating around the MSC crystallites.

The luminescent converter preferably comprises a light guiding element for guiding light emitted by the MSCs to a target location, for example to a photo cell. The MSCs may be disposed on a surface of the light guiding element and/or they may be embedded in the light guiding element. The light guiding element may particularly be a flat transparent plate of glass or plastics.

Furthermore, the luminescent converter may optionally comprise a mirror on at least one of its surfaces in order to prevent light from being emitted in unwanted directions.

The invention further relates to a method of manufacturing a luminescent converter as further defined in the accompanying claims, particularly a converter of the kind described above. The method is characterized in that MSCs are synthesized directly in a light guiding element, for example by sintering silica doped with lead and chalcogenide precursors at elevated temperatures. In this way an element can be produced in a single step that combines light guiding and luminescent properties in the same spatial region.

### BRIEF DESCRIPTION OF THE DRAWINGS

These and other aspects of the invention will be apparent from and elucidated with reference to the embodiment(s) described hereinafter. These embodiments will be described by way of example with the help of the accompanying drawings in which:
Figure 1 schematically shows an exploded perspective view of a solar power generator with a luminescent solar concentrator according to a first embodiment of the invention;
Figure 2 schematically shows an exploded perspective view of a solar power generator with a luminescent solar concentrator according to a second embodiment of the invention;
Figure 3 shows the absorption spectrum and the emission spectrum of MSCs of PbSe dispersed in tetrachloroethylene.

In the Figures, identical reference numbers or numbers differing by integer multiples of 100 refer to identical or similar components.

### DESCRIPTION OF PREFERRED EMBODIMENTS

The present invention will in the following primarily be described with respect to a particular application, i.e. as a "luminescent solar concentrator" LSC comprised by a solar power generator. The concept of the LSC is based on a transparent (polymer or glass) plate containing fluorescent dyes. Solar radiation is absorbed by the dyes and reemitted in all directions. Due to internal reflection within the polymer or glass matrix, most of the reemitted light is guided to the sides of the plate, where solar cells can be attached. A small effective area of solar cells is thus required for a relatively large area that collects the sun, making the device economically favorable.

However, the overall efficiency of state-of-the-art LSCs is still not sufficient to compete with conventional solar cells (Currie, Science 321 (2008) 226). This is due to loss mechanisms, which are caused by
(1) light that is not absorbed by the plate;
(2) light that is reemitted within the escape cone, thereby leaving the plate;
(3) a quantum efficiency of the dye lower than unity;
(4) reabsorption of emitted light due to spectral overlap of the absorption and emission band of the dye. Reabsorption is a major loss mechanism because it introduces a new chance for loss mechanisms (2) and (3) to occur.

The aforementioned loss mechanisms all contribute to an optical efficiency not larger than 25 % (solar cell system efficiency < 5%). So far, every material that has been used in LSCs has certain drawbacks. Organic dyes have high quantum efficiency, but suffer from a small absorption band, a low photo stability, and large spectral overlap between emission and absorption. Apart from fluorescent dyes, semiconductor nanocrystals such as quantum dots or quantum rods, or phosphors (rare earth and transition metals) can be used as fluorophores. These inorganic emitters have the common advantage of generally higher photo stability as compared to organic dyes. Quantum dots (and rods) have the additional advantage of a broad absorption band, but suffer from a small Stokes shift and hence large reabsorption. Phosphors have the advantage of a narrow line emission and large Stokes shift, but often suffer from low absorption cross-sections and a narrow absorption band.

In view of this, the invention disclosed here proposes the use of semiconductor Magic-sized Clusters (MSCs) for spectral down conversion of light, for instance by using MSCs as fluorescent material in a luminescent converter, particularly in an LSC. MSCs are small inorganic crystallites with diameters typically smaller than 3 nm. For these very small clusters there exist only a small number of sizes that are thermodynamically stable. These "magic sizes" correspond to a fixed number of atoms that form (symmetric) clusters with a relatively low number of surface atoms, and hence a lower free energy than clusters with a different number of atoms. For larger sizes of crystallites, e.g. quantum dots, this effect becomes smaller and hence many sizes and shapes are possible.

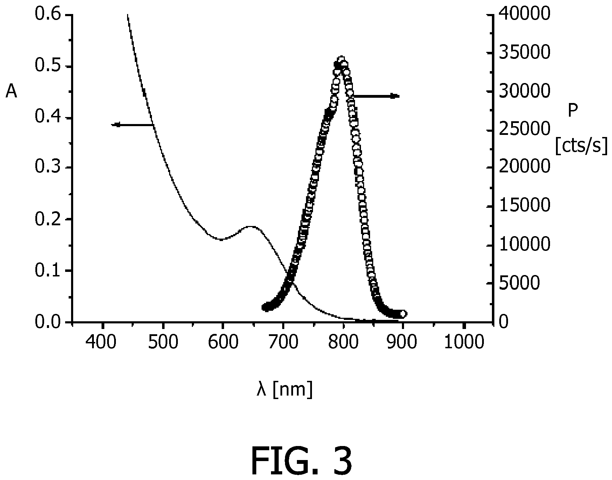

It turns out that MSCs are favorable in view of loss mechanisms (1), (3), and (4) mentioned above, because they provide a highly efficient fluorophore with a broad absorption band and a large Stokes-shift. Figure 3 shows in this respect as an example the optical absorption spectrum (solid line, left axis of absorbance A) and the photoluminescence spectrum (open circles, right axis of photoluminescence P) of PbSe MSCs dispersed in tetrachloroethylene in dependence on the wavelength λ. In more detail, the following advantageous aspects of MSCs are most important:
(a) The emission of for example PbSe MSCs typically lies in the range of 700-900 nm, which matches well with the optimal efficiency region of the conventional silicon solar cell (which is the most attractive candidate for use in LSCs from economical and practical point of view).
(b) The absorption band of MSCs is broad, favoring the absorption of a major part of the incoming solar radiation (cf. Figure 3, left curve).
(c) The overlap between absorption and emission band is small, which is an important advantage of the MSCs compared to for example quantum dots or dyes (cf. Figure 3).
(d) The quantum efficiency (QE) of PbSe MSCs currently ranges between 50-90% (Evans, Nano Letters 2008, 2896). It is expected that this QE can be further enhanced by optimized reaction conditions, or by applying a passivating organic or inorganic coating around the PbSe MSC. MSCs of CdSe may however have a lower QE (Bowers et al., JACS 2005, 127, 15378).
(e) The synthesis of the MSCs is straightforward, at room temperature, and allows for up-scaling towards e.g. gram quantities. It is noted that the yield of the synthesis can be increased by changing the reaction into a continuous process or by reusing the precursor materials that have not reacted.

The absorption and emission bands in Figure 3 were measured for a dispersion containing MSCs of different sizes. This, in combination with a large homogeneous line width, explains the relatively broad emission spectrum of the PbSe MSCs. It also implies that the spectral overlap of a dispersion of one size of MSCs is even smaller than presented for the mixture of sizes in Figure 3. The advantage of a large Stokes shift and a narrow emission band is not only a reduced self-absorption, it also facilitates the design of wavelength-selective mirrors that may be applied to improve the LSC performance, and it increases the maximum possible concentration of light by the LSC. It should be noted that the origin of the large Stokes shift of PbSe MSC is not yet well understood.

The MSCs that may be used according to the invention especially comprise the class of IV-VI semiconductor MSCs, and even more specifically the lead salts (e.g. PbSe). These MSCs have been shown to exhibit unique optical properties that are highly favorable for usage in LSCs. Besides this, also magic-sized clusters of the II-VI semiconductors (e.g. CdSe), III-V semiconductors (e.g. InP), or silicon may be used.

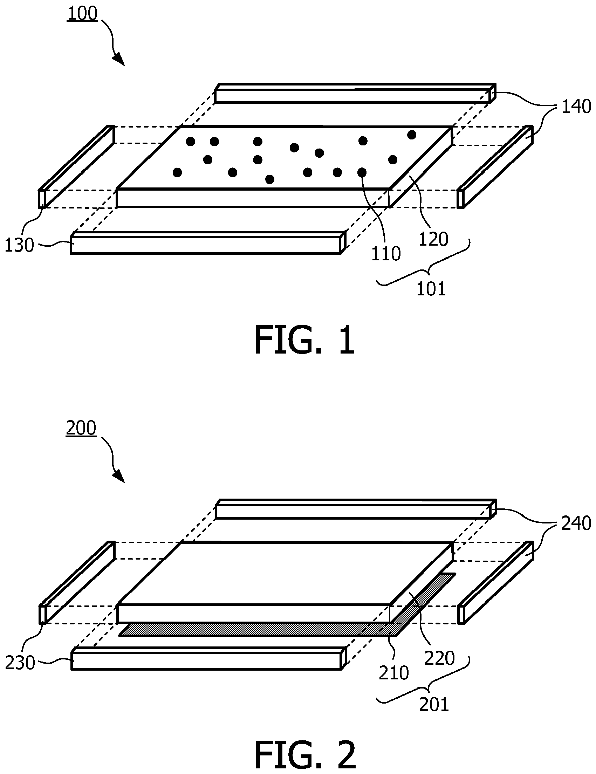

An illustration of a general design of a luminescent solar concentrator LSC 101 is given in Figure 1. The LSC 101 comprises a plate as a matrix 120 containing the fluorophores, in this case the MSCs 110. To the sides of the matrix 120 are attached solar cells 130 and optionally also mirrors 140. The number of solar cells and mirrors, and at which side of the plate they are attached can vary and depends on for example the size and shape of the plate 120. All components together constitute a solar power generator 100.

The matrix 120 or plate should be transparent over a range between 400 nm and 900 nm, and preferably over a range of 300-1000 nm. It may consist of a polymer, or a mixture of polymers, such as methylmethacrylate (PMMA), polycarbonate, laurylmethacrylate (LMA), 2-hydroxyethylmethacrylate (HEMA), and ethyleneglycoldimethacrylate (EGDM). When making the polymer matrix, one can start with the pure monomers, or with prepolymerized materials such as polyethylmethacrylate, or a mixture of monomers and prepolymers. The plate may be flexible for certain applications. The matrix can also consist of an inorganic transparent material such as glass (silicon dioxide), aluminum oxide, or titanium dioxide. The shape of the plate 120 is not necessarily rectangular, it may have any other desired shape.

The MSCs 110 are preferably (but not limited to) the lead salt semiconductors. They can be easily synthesized in large amounts according to a reported batch route (Evans et al., above). To improve (photo) stability and/or the QE of the MSCs, the inorganic clusters may be coated with one or more inorganic semiconductor coatings (cf. Xie et al., J. Am. Chem. Soc., 2005, 127 (20), 7480). For example, PbSe MSCs may be coated with a few monolayers of PbS to passivate the PbSe surface. The thickness of this coating preferably ranges between 0.1 nm and 10 nm. Also organic coatings that passivate the surface and/or facilitate incorporation into a polymer or silica matrix (monomers that attach to the MSC-surface such as functional acrylates or silanes) may be used. After synthesis of the MSCs, some purification steps will be preferred before incorporation in the matrix.

The MSCs 110 may be incorporated in the main body of the matrix 120 as illustrated in Figure 1.

An alternative design is shown in Figure 2. The solar power generator 200 of Figure 2 is largely similar to that of Figure 1 and will therefore not be described again. The essential difference is that the MSCs are applied as a thin layer 210 on top or below of a transparent carrier substrate 220 (e.g. a polymer or glass plate). A typical thickness of the layer 210 ranges between 500 nm and 500 micrometers, preferably between 1 and 100 micrometers.

There will be a preferred concentration of MSCs within the matrix 120 (Figure 1) or top/bottom coating 210 (Figure 2) for optimal performance of the LSC 101 or 201, respectively. In this context, it may be desired to include a concentration gradient of MSCs over the matrix or coating, for example with decreasing concentration towards the sides of the plate where the photo cells 130, 230 and/or the mirrors 140, 240 are located.

The MSCs may optionally be synthesized directly in for example a silica matrix, resulting in an LSC 101 according to Figure 1. This can be achieved by for example sintering silica that is doped with lead and chalcogenide precursors at elevated temperatures.

In another embodiment, different sizes of MSCs are incorporated in the matrix 120 or coating 210 to have a gradient in emission bands. This may result in optimal absorption of solar irradiation, minimal reabsorption losses, and optimal performance of the LSC.

The MSCs may further have different sizes between which radiative or non-radiative energy transfer can take place. In this context, the largest crystallites may be present in smallest concentrations, which lead to further reduction of self-absorption, and no concentration gradient is necessary.

In another embodiment, a combination of MSCs and other fluorophores like dyes, phosphors, quantum dots, or quantum rods are incorporated in the matrix 120 or coating 210. Radiative or non-radiative transfer of energy may take place from the MSCs to the other fluorophores, or vice versa. An MSC may for example act as an absorber of incoming light, transferring the absorbed energy to an acceptor fluorophore, which emits at another wavelength that is shifted to lower energy.

Moreover, the MSC (or a shell around the MSC) may be doped with line-emitters such as rare-earth ions. The energy absorbed by the MSCs can be transferred to the rare-earth ions, and reemitted at their specific emission lines. This reduces reabsorption by the MSCs even further because the line-emission of the rare-earth ion can be selected to be sufficiently red-shifted from the absorption band of the MSCs and the line emitter transitions correspond to forbidden transitions. For emission of MSCs between 700-900 nm possible ions are for example, but not exclusive: Nd, Dy, Ho, Er, Tm. Furthermore, the line-emission also facilitates the use of interference filters to keep the emitted light within the matrix.

Regarding the solar cells 130 and 230, the choice depends on optimal coverage of the emission band of the MSCs in use, overall efficiency, costs, and possibility to manufacture the cell with the required dimensions. Silicon solar cells meet most of these requirements, and especially have an optimal performance in a wavelength range that matches very well with the emission band of lead salt MSCs. Depending on the particular efficiency/cost desires of an LSC, one of the existing types of silicon solar cells (single crystal, multicrystalline, amorphous, or thin film) will thus be preferred.

GaAs or InGaP cells are more expensive but may be advantageous in case a high overall efficiency of the LSC is desired. Thin film CdTe solar cells, dye sensitized solar cells, organic solar cells, or tandem cells may also be advantageous in some specific cases. In case of a non-rectangular shaped LSC, it may be desired to use a flexible solar cell that can adapt to the shape of the LSC.

The invention is specifically applicable to the field of luminescent solar concentrators, or more in general to efficient spectral down converters for solar cells. It could also be applied for spectral down conversion in LEDs or other lighting applications.

Finally it is pointed out that in the present application the term "comprising" does not exclude other elements or steps, that "a" or "an" does not exclude a plurality, and that a single processor or other unit may fulfill the functions of several means. The invention resides in each and every novel characteristic feature and each and every combination of characteristic features. Moreover, reference signs in the claims shall not be construed as limiting their scope.

## Claims

1. A solar power generator (100, 200), comprising:
- a luminescent solar concentrator with a luminescent converter (101, 201) comprising magic-sized clusters (110, 210), called MSCs, of luminescent material;
- a photo cell (130, 230) that is arranged to receive light emissions of the luminescent converter.

2. The solar power generator (100, 200) according to claim 1,
**characterized in that** the MSCs (110, 210) have a diameter smaller than or equal to 3 nm.

3. The solar power generator (100, 200) according to any one of the preceding claims,
**characterized in that** the MSCs (110, 210) are symmetric crystallites.

4. The solar power generator (100, 200) according to any one of the preceding claims,
**characterized in that** the MSCs (110, 210) comprise a compound of two elements taken from groups IV and VI, or groups II and VI, or groups III and V of the periodic table of elements, or from a single element from group IV of the periodic table of elements.

5. The solar power generator (100, 200) according to any one of the preceding claims,
**characterized in that** the MSCs (110, 210) comprise a compound selected from the group consisting of PbSe and other salts, CdSe, InP, GaAs, and Si.

6. The solar power generator (100, 200) according to any one of the preceding claims,
**characterized in that** the MSCs (110, 210) are covered with a coating, particularly a coating comprising an organic material and/or an inorganic semiconductor like PbS.

7. The solar power generator (100, 200) according to any one of the preceding claims,
**characterized in that** the MSCs (110, 210) or a coating thereof comprise a line-emitting dopant, particularly a rare-earth element like Nd, Dy, Ho, Er, or Tm.

8. The solar power generator (100, 200) according to any one of the preceding claims,
**characterized in that** MSCs (110, 210) have different sizes, which are preferably distributed in such way that radiative or non-radiative energy transfer can take place between the MSCs.

9. The solar power generator (100, 200) according to any one of the preceding claims,
**characterized in that** the concentration of the MSCs (110, 210) varies spatially within the luminescent converter, having preferably lower values near a border of the luminescent converter.

10. The solar power generator (100, 200) according to any one of the preceding claims,
**characterized in that** it comprises additional fluorophores besides the MSCs (110, 210), particularly organic dyes, inorganic phosphors, or quantum dots or quantum rods.

11. The solar power generator (100, 200) according to any one of the preceding claims,
**characterized in that** it comprises a light guiding element (120, 220) for guiding light emitted by the MSCs (110, 210) to a target location (130, 230), particularly a light guiding element made of glass or a polymer.

12. The solar power generator (100, 200) according to claim 11,
**characterized in that** the MSCs (110) are embedded in the light guiding element (120) and/or that the MSCs (210) are embedded in a thin film on the surface of the light guiding element (220).

13. A method of manufacturing a luminescent converter (101), particularly for a solar generator according to any one of the preceding claims,
**characterized in that** MSCs (110) are synthesized directly in a light guiding element by a sintering method.

## Patentansprüche

1. Solarenergiegenerator (100, 200), Folgendes umfassend:
- einen lumineszierenden Solarkonzentrator mit einem lumineszierenden Konverter (101, 201), der Magic-Sized-Clusters (110, 210), MSCs genannt, aus lumineszierendem Material umfasst,
- eine Fotozelle (130, 230), die dafür angeordnet ist, Lichtemissionen des lumineszierenden Konverters zu empfangen.

2. Solarenergiegenerator (100, 200) nach Anspruch 1,
**dadurch gekennzeichnet, dass** die MSCs (110, 210) einen Durchmesser aufweisen, der kleiner oder gleich 3 nm ist.

3. Solarenergiegenerator (100, 200) nach einem der vorhergehenden Ansprüche,
**dadurch gekennzeichnet, dass** die MSCs (110, 210) symmetrische Kristallite sind.

4. Solarenergiegenerator (100, 200) nach einem der vorhergehenden Ansprüche,
**dadurch gekennzeichnet, dass** die MSCs (110, 210) eine Verbindung aus zwei Elementen umfassen, die den Gruppen IV und VI oder den Gruppen II und VI oder den Gruppen III und V des Periodensystems der Elemente entstammen, oder aus einem einzigen Element aus Gruppe IV des Periodensystems der Elemente.

5. Solarenergiegenerator (100, 200) nach einem der vorhergehenden Ansprüche,
**dadurch gekennzeichnet, dass** die MSCs (110, 210) eine Verbindung umfassen, die aus der Gruppe ausgewählt ist, die aus PbSe und anderen Salzen, CdSe, InP, GaAs und Si besteht.

6. Solarenergiegenerator (100, 200) nach einem der vorhergehenden Ansprüche,
**dadurch gekennzeichnet, dass** die MSCs (110, 210) mit einer Beschichtung bedeckt sind, insbesondere einer Beschichtung, die ein organisches Material und/oder einen anorganischen Halbleiter wie PbS umfasst.

7. Solarenergiegenerator (100, 200) nach einem der vorhergehenden Ansprüche,
**dadurch gekennzeichnet, dass** die MSCs (110, 210) oder eine Beschichtung derselben eine linien-emittierende Dotiersubstanz umfasst, insbesondere ein Seltenerdenelement wie Nd, Dy, Ho, Er oder Tm.

8. Solarenergiegenerator (100, 200) nach einem der vorhergehenden Ansprüche,
**dadurch gekennzeichnet, dass** die MSCs (110, 210) unterschiedliche Größen aufweisen, die vorzugsweise derart verteilt sind, dass zwischen den MSCs (110, 210) eine Übertragung von Strahlungsenergie oder Nicht-Strahlungsenergie stattfinden kann.

9. Solarenergiegenerator (100, 200) nach einem der vorhergehenden Ansprüche,
**dadurch gekennzeichnet, dass** die Konzentration der MSCs (110, 210) innerhalb des lumineszierenden Konverters räumlich variiert und nahe einem Rand des lumineszierenden Konverters vorzugsweise niedrigere Werte aufweist.

10. Solarenergiegenerator (100, 200) nach einem der vorhergehenden Ansprüche,
**dadurch gekennzeichnet, dass** er neben den MSCs (110, 210) zusätzliche Fluorophore umfasst, insbesondere organische Farbstoffe, anorganische Phosphore oder Quantenpunkte oder Quantenstäbchen.

11. Solarenergiegenerator (100, 200) nach einem der vorhergehenden Ansprüche,
**dadurch gekennzeichnet, dass** er ein Lichtleiterelement (120, 220) zum Leiten des von den MSCs (110, 210) emittierten Lichts zu einer Zielposition (130, 230) umfasst, insbesondere ein Lichtleiterelement, das aus Glas oder einem Polymer besteht.

12. Solarenergiegenerator (100, 200) nach Anspruch 11,
**dadurch gekennzeichnet, dass** die MSCs (110) in das Lichtleiterelement (120) eingebettet sind und/oder dass die MSCs (210) in eine Dünnschicht auf der Oberfläche des Lichtleiterelements (220) eingebettet sind.

13. Verfahren zur Herstellung eines lumineszierenden Konverters (101), insbesondere für einen Solargenerator nach einem der vorhergehenden Ansprüche,
**dadurch gekennzeichnet, dass** MSCs (110) durch ein Sinterverfahren direkt in ein Lichtleiterelement eingebaut werden.

## Revendications

1. Générateur d'énergie solaire (100, 200), comprenant :
- un concentrateur solaire luminescent avec un convertisseur luminescent (101, 201) comprenant des agrégats à nombre magique (110, 210), appelés MSC, de matériau luminescent ;
- une cellule photoélectrique (130, 230) qui est agencée pour recevoir les émissions de lumière du convertisseur luminescent.

2. Générateur d'énergie solaire (100, 200) selon la revendication 1,
**caractérisé en ce que** les MSC (110, 210) ont un diamètre inférieur ou égal à 3 nm.

3. Générateur d'énergie solaire (100, 200) selon l'une quelconque des revendications précédentes,
**caractérisé en ce que** les MSC (110, 210) sont des cristallites symétriques.

4. Générateur d'énergie solaire (100, 200) selon l'une quelconque des revendications précédentes,
**caractérisé en ce que** les MSC (110, 210) comprennent un composé de deux éléments pris dans les groupes IV et VI, ou les groupes II et VI, ou les groupes III et V de la table périodique des éléments, ou un élément unique du groupe IV de la table périodique des éléments.

5. Générateur d'énergie solaire (100, 200) selon l'une quelconque des revendications précédentes,
**caractérisé en ce que** les MSC (110, 210) comprennent un composé sélectionné dans le groupe consistant en le PbSe et d'autres sels, CdSe, InP, GaAs et Si.

6. Générateur d'énergie solaire (100, 200) selon l'une quelconque des revendications précédentes,
**caractérisé en ce que** les MSC (110, 210) sont recouverts d'un revêtement, en particulier un revêtement comprenant un matériau organique et/ou un semi-conducteur inorganique tel que le PbS.

7. Générateur d'énergie solaire (100, 200) selon l'une quelconque des revendications précédentes,
**caractérisé en ce que** les MSC (110, 210) ou un revêtement de ceux-ci comprennent un dopant d'émission de raies, en particulier un élément des terres rares tel que le Nd, Dy, Ho, Er, ou Tm.

8. Générateur d'énergie solaire (100, 200) selon l'une quelconque des revendications précédentes,
**caractérisé en ce que** les MSC (110, 210) ont différentes tailles, qui sont réparties de préférence de manière à ce qu'un transfert d'énergie radiatif ou non-radiatif puisse avoir lieu entre les MSC.

9. Générateur d'énergie solaire (100, 200) selon l'une quelconque des revendications précédentes,
**caractérisé en ce que** la concentration des MSC (110, 210) varie spatialement dans le convertisseur luminescent, ayant des valeurs de préférence plus faibles à proximité d'une bordure du convertisseur luminescent.

10. Générateur d'énergie solaire (100, 200) selon l'une quelconque des revendications précédentes,
**caractérisé en ce qu'**il comprend des fluorophores supplémentaires en plus des MSC (110, 210), en particulier des colorants organiques, des phosphores inorganiques, ou des points quantiques ou des barres quantiques.

11. Générateur d'énergie solaire (100, 200) selon l'une quelconque des revendications précédentes,
**caractérisé en ce qu'**il comprend un élément de guidage de lumière (120, 220) pour guider la lumière émise par les MSC (110, 210) vers un emplacement cible (130, 230), en particulier un élément de guidage de lumière constitué de verre ou de polymère.

12. Générateur d'énergie solaire (100, 200) selon la revendication 11,
**caractérisé en ce que** les MSC (110) sont intégrés dans l'élément de guidage de lumière (120) et/ou **en ce que** les MSC (210) sont intégrés dans un film mince sur la surface de l'élément de guidage de lumière (220).

13. Procédé de fabrication d'un convertisseur luminescent (101), en particulier pour un générateur solaire selon l'une quelconque des revendications précédentes,
**caractérisé en ce que** les MSC (110) sont synthétisés directement dans un élément de guidage de lumière par un procédé de frittage.
